## Europäisches Patentamt
## European Patent Office
## Office européen des brevets

(19)

(11) Numéro de publication: **0 032 069**
**B1**

(12) **FASCICULE DE BREVET EUROPEEN**

(45) Date de publication du fascicule du brevet: **09.05.84**

(51) Int. Cl.³: **H 01 L 29/91, H 01 L 23/56**

(21) Numéro de dépôt: **80401617.8**

(22) Date de dépôt: **12.11.80**

(54) **Procédé d'ajustement du coefficient de température d'une diode de référence et diode de référence obtenue.**

(30) Priorité: **28.12.79 FR 7931972**

(43) Date de publication de la demande:
**15.07.81 Bulletin 81/28**

(45) Mention de la délivrance du brevet:
**09.05.84 Bulletin 84/19**

(84) Etats contractants désignés:
**DE FR GB**

(56) Documents cités:
**US - A - 3 798 510**
**US - A - 4 053 924**
**US - A - 4 146 906**

**MOTOROLA ZENER DIODE HANDBOOK (Cité par le demandeur)**

(73) Titulaire: **THOMSON-CSF**
**173, Boulevard Haussmann**
**F-75379 Paris Cedex 08 (FR)**

(72) Inventeur: **Valdman, Henri**
**"THOMSON-CSF" SCPI 173, bld Haussmann**
**F-75360 Paris Cedex 08 (FR)**

(74) Mandataire: **de Beaumont, Michel et al,**
**THOMSON-CSF SCPI 173, Bld Haussmann**
**F-75379 Paris Cedex 08 (FR)**

Courier Press, Leamington Spa, England.

**Description**

La présente invention concerne un procédé de compensation d'une diode de référence compensée en température, conformément au préambule de la revendication 1 et une diode ainsi compensée.

Dans de très nombreux circuits discrets ou intégrés à semiconducteurs, il est nécessaire de disposer d'une tension de référence. Une telle tension peut être fournie par une diode Zener. Néanmoins, un inconvénient de l'emploi de diodes Zener seules est que ces diodes présentent des coefficients de température relativement élevés et positifs dès que leur tension dépasse une valeur de sensiblement 4,5 Volts. Ainsi, pour constituer des diodes de référence, il est d'usage de mettre en série avec une diode Zener à coefficient de température positif des diodes à jonction classiques à coefficient de température négatif pour permettre ainsi une compensation des coefficients de température. Ce procédé souffre de l'inconvénient que les diodes classiques présentent des coefficients de température sensiblement constants et qu'on ne peut donc réaliser une compensation stricte du coefficient de température de la diode Zener que pour certaines valeurs particulières des coefficients de température de ces diodes Zener, c'est-à-dire seulement pour certaines valeurs de la tension Zener.

Un objet de la présente invention est de prévoir un procédé conforme à la revendication 1 d'ajustement du coefficient de température d'une diode à jonction polarisée en direct permettant en particulier d'obtenir une variation de la tension $(dV/dT)_F$ de l'ordre de — 2mV/°C.

Un autre objet de la présente invention, conforme aux revendications 2 à 5, est de prévoir une diode de référence pouvant être compensée de façon relativement rigoureuse en température pour un domaine étendu de tensions Zener.

Pour atteindre ces objets, la présente invention prévoit un procédé d'ajustement du coefficient de température d'une diode polarisée en direct consistant à sélectionner la distance entre la jonction et l'électrode recombinante de cette diode, cette distance étant nettement inférieure à la valeur de la longueur de diffusion des porteurs minoritaires dans la couche intermédiaire.

La présente invention prévoit aussi une diode de référence compensée en température comprenant une diode Zener en série avec au moins une diode à jonction en direct, l'une au moins de ces diodes en direct étant du type à électrode recombinante, c'est-à-dire présentant une électrode disposée à une distance choisie de la jonction nettement inférieure à la valeur de la longueur de diffusion des porteurs minoritaires dans la couche semiconductrice intermédiaire comprise entre la jonction et l'électrode. La diode à électrode recombinante peut comprendre au-dessus de la couche semiconductrice intermédiaire une couche de silicium polycristallin dopé selon le même type de conductivité que cette couche intermédiaire. La couche intermédiaire peut avoir un niveau de dopage de l'ordre de $10^{15}$ at/cm$^3$ et une épaisseur de l'ordre de 2 à 5 microns.

Le brevet américain 4 053 924 préconise l'emploi d'une diode à électrode recombinante pour améliorer plusieurs caractéristiques d'une diode, à savoir la durée de recouvrement en direct et en inverse, la faible valeur de la tension de conduction en direct, la possibilité de supporter des courants élevés, l'obtention d'un faible courant inverse, l'obtention d'une forte stabilité dans un environnement rayonnant. Néanmoins, ce document est muet sur les caractéristiques de température et de coefficient de température d'une telle diode.

Ces objets, caractéristiques et avantages ainsi que d'autres de la présente invention seront exposés plus en détail dans la description suivante faite en relation avec les figures jointes parmi lesquelles:

la figure 1 représente une chaîne de diodes selon la présente invention;

la figure 2 représente un mode de réalisation de diodes à électrode recombinante selon la présente invention;

la figure 3 représente une courbe illustrant la variation de la chute de tension en direct d'une diode en fonction de la concentration d'or;

les figures 4A à 4D représentent des étapes préliminaires de fabrication d'une diode selon l'invention;

les figures 5A et 5B illustrent un mode de réalisation d'une chaine de diodes selon la présente invention;

la figure 6 représente une variante de diode à électrode recombinante selon la présente invention.

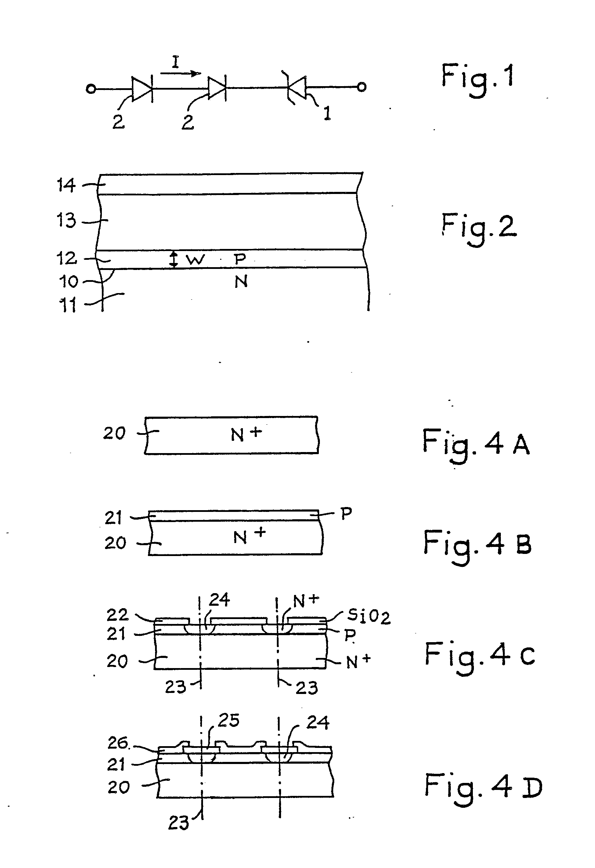

la figure 1 représente une diode de référence selon la présente invention. Cette diode comprend une diode Zener 1 en série avec des diodes à jonction polarisées en direct 2, le courant circulant dans le sens indiqué par la flèche I. On pourra trouver une description de ce mode de compensation dans l'ouvrage de la Société Motorola institulé "Motorola Zener Diode Handbook" 1967 — Chapitre 5.

La figure 5—4 de ce chapitre 5 et la description correspondante indiquent qu'en utilisant des diodes à jonction classiques, on ne peut obtenir une compensation de température convenable que pour des valeurs particulières de la tension de la diode de référence, et pour des surfaces données des diodes, ainsi, avec une diode Zener de facteur de température $(dV/dT)_z$ donné, on peut obtenir une compensation de température avec un certain nombre choisi de diodes de coefficient de température négatif $(dV/dt)_F$ (l'indice F indique que la diode est polarisée dans le sens direct).

La présente invention se base sur une analyse théorique approfondie des paramètres commandant la valeur des facteurs de température

$$\left[\frac{dV}{dt}\right]$$

d'une diode polarisée en direct. Ce facteur de température peut s'écrire:

$$\left[\frac{dV}{dt}\right]_F = \frac{V_F - E_{g/q}}{T} - \frac{3k}{q} \quad (1)$$

dans cette équation:

$V_F$ désigne la chute de tension en direct dans la diode,

$E_g$ désigne l'intervalle de bande interdite dans le semiconducteur,

T désigne la température absolue,

k la constante de Boltzman,

q la charge élémentaire de l'électron.

A part $V_F$, tous les paramètres apparaissant dans l'expression de $(dV/dt)_F$ sont des données, sauf bien entendu T qui désigne la température absolue, mais l'on ne peut également pas jouer sur ce facteur.

$V_F$ s'exprime par l'équation:

$$V_F = \frac{nkT}{q} \, Log \, \frac{I_F}{J_0 S} \quad (2)$$

où n est un paramètre ayant une valeur variant entre 1 et 2 en fonction des caractéristiques du semiconducteur et en particulier de la longueur de diffusion des porteurs minoritaires dans ce semiconducteur.

$I_F$ désigne le courant passant dans le sens direct dans la diode. Généralement, dans l'utilisation en diode de référence, ce courant est fixé par le constructeur.

S désigne la surface de jonction de la diode. Cette surface de jonction est déterminée une fois que l'on a choisi la surface de la diode Zener étant donné que la diode en direct est généralement montée sous forme d'une pastille soudée sur la diode Zener et a sensiblement la même dimension que celle-ci.

Donc, pour agir sur la valeur de $V_F$, il convient d'agir sur la valeur de $J_0$ qui désigne la densité de courant dans la diode et qui s'écrit:

$$J_0 = n_i^2 q \left[\frac{D_p}{NL_p} + \frac{D_n}{PL_n}\right] \quad (3)$$

Dans cette expression, $n_i$ désigne la concen-tration intrinsèque de porteurs de charge; $D_p$ et $D_n$ désignent les coefficients de diffusion des trous et des électrons respectivement; $L_p$ et $L_n$ les longueurs de diffusion des trous et des électrons respectivement; et P et N désignent respectivement la concentration des trous dans la région P et la concentration des électrons dans la région N. Dans le cas général où la jonction est très dissymétrique, c'est-à-dire où l'une des couches formant cette jonction est nettement plus dopée que l'autre, par exemple dans laquelle la concentration des impuretés dopantes dans a couche de type P est nettement supérieure à la concentration des impuretés dopantes dans la région de type N, on a N ≫ P et on peut écrire:

$$J_0 \neq n_i^2 q \, \frac{D_n}{PL_n} \quad (4)$$

Ainsi, dans l'art antérieur, quand on voulait modifier le coefficient de température en diminuant $V_F$, c'est-à-dire en augmentant $J_0$, on a utilisé comme moyen pour atteindre ce résultat une diminution de la longueur de diffusion $L_n$ en effectuant une diffusion à l'or dans la couche de type P. Néanmoins l'emploi de ce procédé est limité car, comme on l'a vu précédemment, la valeur de n dans l'expression de $V_F$ dépend également de la longueur de diffusion et la variation de n se fait dans le même sens que celle de $J_0$. Ces deux coefficients étant respectivement au numérateur et au dénominateur de l'expression de $V_F$, leurs effets se compensent et l'on ne peut atteindre que de faibles diminutions de la valeur de $V_F$, c'est-à-dire du coefficient de température.

La courbe de la figure 3 indique l'allure de la variation de $V_F$ en fonction de la concentration d'or en unités arbitraires. On voit que l'on ne peut descendre en dessous d'un minimum.

L'une des bases de la présente invention a été de réaliser que, comme cela est d'ailleurs connu dans le cas général, l'équation (4) ci-dessus correspond en fait à un cas particulier dans lequel l'épaisseur de la couche la moins dopée des deux couches formant la jonction est suffisamment importante. En effet, dans le cas général de réalisation pratique des diodes semiconductrices, on évite d'avoir des épaisseurs de semiconducteur très faibles par rapport à la longueur de diffusion entre la surface de la jonction et la surface de l'électrode car alors on risque d'avoir un mauvais contact ohmique entre l'électrode et la couche sous-jacente et, de toute manière, on détériore les caractéristiques inverses de la diode qui présente alors un courant de fuite en inverse relativement élevé. Ainsi, on considère toujours dans les divers cas pratiques des diodes semiconductrices présentant des épaisseurs de couches semiconductrices relativement importantes de part et d'autre de la jonction. Mais, comme l'indiquent par exemple les pages 157 et 158 de l'ouvrage théorique de P. Aigrain et F. Englert publié aux Editions Dunod, dans le cas où l'épaisseur W de la couche semiconductrice située entre la jonction et son électrode est très inférieure à la longueur de diffusion des porteurs minoritaires dans la couche intermédiaire, on obtient une structure dite à électrode recombinante pour laquelle l'équation (4) peut s'écrire:

$$J_0' = n_i^2 q \, \frac{Dn}{PW} \qquad (5)$$

ou encore:

$$J_0' = n_i^2 q \, \frac{Dn}{PLn} \times \frac{Ln}{W} = J_0 \frac{LN}{W} \qquad (6)$$

On a couramment pour du silicium de type P dopé à $10^{15}$ at/cm$^3$ une durée de vie de l'ordre de 1 microseconde d'où une longueur de diffusion des électrons

$$L_n = \sqrt{35 \times 10^{-6}} = 60 \text{ microns}$$

soit pour une couche W = 2 microns un rapport Ln/W = 30.

Ainsi, en choisissant de façon appropriée la valeur de W, on peut modifier la valeur de $J_0$ du rapport $L_n$/W. Ce rapport peut facilement être rendu égal à une valeur de l'ordre de 30. En conséquence, bien que la dépendance entre $V_F$ et $J_0$ soit logarithmique, on peut faire varier de façon notable la valeur de $V_F$ et par conséquent la valeur de coefficient de température $(dV/dt)_F$.

Ainsi, selon la présente invention, il est envisagé d'utiliser des diodes à électrode recombinante contrairement à un préjugé établi dans la technique, dans le but particulier de réaliser une diode à coefficient de température réglable quand cette diode fonctionne dans le sens direct.

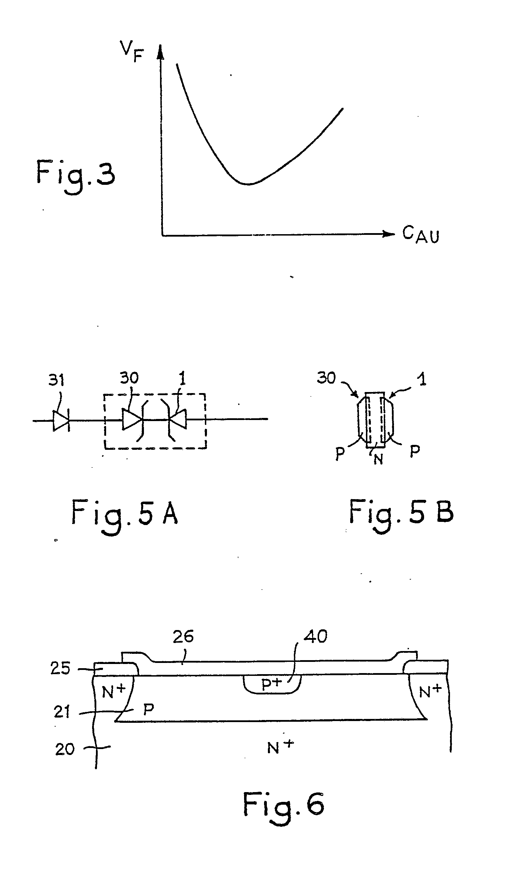

Il n'en demeure pas moins que cette diode aura de mauvaises caractéristiques en inverse, mais, dans l'application particulière envisagée relative à la fabrication de diodes de référence, la tenue en inverse des diodes de compensation est une caractéristique sans importance, ces diodes étant généralement amenées à fonctionner dans le sens direct. Toutefois, si l'on tient à ce que l'ensemble du montage série illustré en figure 1 présente une bonne tenue en inverse, on pourra choisir l'une des diodes du type à électrode recombinante associée à une autre diode classique assurant la tenue en tension inverse. Un autre aspect de cette question sera envisagé ci-après en relation avec les figures 5 et 6.

Un autre aspect de la présente invention est de prévoir une structure particulière de diode à électrode recombinante. On considérera une diode constituée d'une jonction 10 entre une couche 11 de type N et une couche 12 de type P à niveau de dopage moins élevé que celui de la couche de type N. La façon la plus simple d'obtenir une diode à électrode recombiante à partir d'une telle structure consiste à former par épitaxie une couche 12 d'une épaisseur W choisie mettement inférieure à la longueur de diffusion des porteurs minoritaires dans cette couche, puis à revêtir la surface supérieure de la couche 12 d'une métallisation d'aluminium.

Une telle métallisation en aluminium permet d'éviter l'apparition de phénomènes du type Schottky. Toutefois, dans la pratique, on souhaite souvent encapsuler les diodes de référence dans des boîtiers de verre qui en assurent une excellente protection. Dans l'état actuel de la technique, ces boîtiers de verre doivent être scellés, avec les verres couramment disponibles, à des températures supérieures à 600°C. Ceci interdit l'emploi de la couche d'aluminium évoquée précédemment, la température de scellement étant supérieure à la température de l'eutectique silicium/aluminium (570°C) et entraînant une mise en court-circuit de la jonction ou du moins la dégradation de la propriété recherchée.

Ainsi, il est suggéré selon la présente invention, de la façon illustrée en figure 2, de déposer au-dessus de la couche épitaxiée 12 une couche de silicium polycristallin 13 fortement dopée de type P$^+$ 13 elle-même revêtue d'une couche ou d'un ensemble de couches de métallisation 14 (par exemple une métallisation titane-argent). La demanderesse a vérifié qu'avec une telle structure, comme dans le cas où une métallisation est directement déposée à la surface de la couche 12, on obtient bien une densité de courant obéissant aux équations (5) et (6) rappelées ci-dessus sans produire d'effet Schottky, c'est-à-dire que l'interface silicium polycristallin/silicium mono-cristallin agit comme une électrode recombiante tandis que la liaison silicium poly-cristallin/électrode métallique est ohmique et peu résistante.

Un avantage d'une telle structure réside notamment dans le fait que, même si l'on chauffe à des températures relativement élevées, supérieures à 600°C, lors des étapes d'encapsulation, la couche de silicium polycristallin sert de couche tampon et évite une diffusion du métal des couches de métallisations 14 dans la couche 12 de type P constituant l'une des couches de la jonction.

Les figures 4A, B, C et D illustrent certaines étapes préliminaires de fabrication d'une diode à jonction à coefficient de température réglable selon la présente invention. On part d'un substrat 20 de type N$^+$ (figure 4A) sur lequel est formée par épitaxie une couche de type P d'épaisseur ajustée 21. La concentration du substrat 20 peut être de l'ordre de $5 \times 10^{18}$ at/cm$^3$ et celle de la couche P de l'ordre de $10^{15}$ at/cm$^3$. Comme le montre la figure 4C, on forme ensuite sur la couche de type P une couche de silice 22 dans laquelle sont formées des ouvertures en quadrillage aux emplacements correspondants aux limites des diodes élémentaires que l'on veut fabriquer. A travers ces ouvertures, sont diffusées des impuretés de type N$^+$ (comme le substrat) pour former des murs 24. On masque ensuite la face supérieure des murs par une couche de silice 25 (figure 4D) et l'on procède au dépôt 26 de métallisations ou d'une couche de silicium poly-cristallin suivie de métallisations, après quoi les plaquettes représentées sont découpées selon les traits en pointillés 23 pour fournir des diodes élémentaires. Dans les figures 4A à 4D on n'a pas représenté les opérations effectuées sur la couche inférieure de la plaquette, sur la face du substrat $N^+$ opposée à la jonction. En fait, on formera généralement sur cette face une couche surdopée du type $N^+$ avant de réaliser une métallisation, comme cela est bien connu dans la technique de la fabrication des semiconducteurs.

Avec les niveaux de dopage indiqués ci-dessus, la couche de type P peut avoir une épaisseur de l'ordre de 2 à 5 microns. Les métallisations peuvent être formées d'une superposition d'une couche de titane d'une épaisseur de k500 (0,05 microns) Angströem suivie d'une couche d'argent évaporée sous vide de l'ordre d'un micron et d'une deuxième couche d'argent déposée par électrolyse d'une épaisseur de l'ordre de 30 microns.

Le tableau ci-dessous permet de comparer les résultats obtenus avec une diode classique, avec une diode classique diffusée à l'or, et avec une diode à électrode recombinante.

| | $V_F$ (V) | $\left[\dfrac{dV}{dt}\right]_F$ (mV/°C) | RZ à 7,5 mA($\Omega$) |
|---|---|---|---|
| Jonction classique type Zener (0,26 × 0,26 mm) | 0,77 | −1,4 | 5 |
| Jonction $N^+N$ $P^+$ diffusion à l'or (0,26 × 0,26 mm) | 0,66 | −1,8 | 7 à 8 |
| Jonction $N^+P$ a l'électrode recombinante (0,20 × 0,20 mm) Ln/W#25 | 0,6 | −2 | 5 |

Les deux premières colonnes du tableau permettent de montrer qu'avec une électrode recombinante selon la présente invention, on peut obtenir une diminution de $V_F$ et une augmentation du facteur de température (dV/dt) la diminution de $V_F$ et l'augmentation de $(dV/dt)_F$ pouvant être nettement plus importantes que dans le cas où l'on utilise le procédé connu de diffusion d'or. D'autre part, la dernière colonne indique les valeurs de la résistance d'ensemble de la diode de référence dans le sens conducteur ($R_z$) pour un courant donné de 7,5 mA. On voit que, alors que la diffusion à l'or fait croître la valeur de cette résistance de perte dans le sens direct, l'utilisation d'une électrode recombinante permet de ne pas modifier la valeur de cette résistance de perte.

La présente invention a été illustrée ci-dessus dans le cadre particulier d'une structure silicium $N^+$, silicium P, électrode recombinante. On aurait aussi pu envisager une structure de silicium de type $P^+$, silicium de type N, électrode recombinante. D'autre part, en figure 4, on a donné l'exemple d'une structure de type planar. Une structure de type mesa pourrait également être envisagée.

Dans le cas fréquent où on a une diode Zener en série avec deux diodes de compensation en direct, on adoptera de préférence la configuration illustrée en figures 5A et 5B. La diode Zener, désignée par la référence 1, est réalisée sur la même puce de silicium qu'une diode en direct 30, la diode à électrode recombinante 31 étant en série. en ce cas, la diode 30 a les mêmes caractéristiques inverses que la diode Zener 1, ces deux diodes étant par exemple réalisées sous forme de deux boutons épitaxiés de type P réalisées sur les deux faces d'un substrat de type N. La tension de claquage de la diode 30 sera faible, par exemple de l'ordre de 7 volts.

En conséquence, si une surtension inverse importante se produit, c'est la diode à électrode recombinante 31 qui la subira, cette diode ayant une tension de claquage de l'ordre de 80 volts par exemple. Mais, pour cette diode 31, ce claquage risque d'être destructeur si la diode a une configuration du type illustré en figures 2 et 4D. Pour résoudre ce problème, et selon une variante de la présente invention, il est prévu d'insérer une diode de protection dans la structure de diode à électrode combinante, par exemple de la façon illustrée en figure 6.

Dans la figure 6, de mêmes références désignent de mêmes couches qu'en figure 4D. La diode de protection est réalisée par une couche 40, de même type P que la couche 21, mais à niveau de dopage beaucoup plus élevé. On pourra ainsi obtenir dans la zone correspondant à la couche $P^+$ une tension de claquage en inverse plus faible, par exemple de l'ordre de 30 volts si la tension de claquage sous cette couche étaite de l'oredre de 80 volts. Le claquate n'est alors plus destructeur. La surface occupée par la couche 40 de type P$^+$ sera faible devant la surface occupée par la couche de type P 21 pour ne pas affecter notablement le fonctionnement en direct. Par exemple, si la diode globale présente un carré de 0,25 mm de côté, la couche 40 représentera un carré de 0,08 mm de côté.

La présente invention n'est pas limitée aux modes de réalisation qui ont été explicitement décrits ci-dessus; elle en inclut les diverses variantes et généralisations comprises dans le domaine des revendications ci-après.

## Revendications

1. Procédé de fabrication d'une diode de référence dont le coefficient de température dV/dT est nul, cette diode de référence comprenant une diode Zener en série avec au moins une diode à jonction en direct, caractérisé en ce que l'une au moins de ces diodes en direct est choisie du type à électrode recombinante — c'est-àdire que l'épaisseur de la couche intermédiaire entre la jonction et une électrode de cette diode est nettement inférieure à la valeur de la longueur de diffusion des porteurs minoritaires dans cette couche — et en ce que l'épaisseur de la couche intermédiaire est réglée pour annuler le coefficient de température de l'ensemble.

2. Diode de référence obtenue par le procédé selon la revendication 1, caractérisée en ce que la diode à électrode recombinante comprend au-dessus de la couche semiconductrice intermédiaire une couche de silicium polycristallin dopée selon le même type de conductivité que ladite couche intermédiaire.

3. Diode de référence obtenue par le procédé selon la revendication 1, caractérisée en ce que la couche intermédiaire a un niveau de dopage de l'ordre de $10^{15}$ at/cm$^3$ et une épaisseur de l'ordre de 2 à 5 microns.

4. Diode de référence selon la revendication 2, caractérisée en ce que la couche de silicium polycristallin est revêtue d'une couche de titane, elle-même revêtue d'une couche d'argent déposée sous vide suivie d'une couche d'argent déposée électrolytiquement.

5. Diode de référence obtenue par le procédé selon la revendication 1, caractérisée en ce que, dans une partie de la couche intermédiaire, est formée une zone de même type de conductivité mais à niveau de dopage élevé pour réduire la tension de claquage inverse.

## Claims

1. Method of fabricating a reference diode whose temperature coefficient dV/dT is zero, said reference diode comprising a Zener diode in series with at least one diode with forward junction, characterized in that at least one of said diodes with forward junction is selected to be of the type with recombining electrode, i.e.

the thickness of the intermediate layer between junction and electrode of said diode is substantially less than the value of the diffusion length of the minority carriers in said layer, and that the thickness of the intermediate layer is adjusted to render the temperature coefficient of the unit zero.

2. Reference diode obtained by the method according to claim 1, characterized in that the diode with recombining electrode comprises above the semiconductor intermediate layer a layer of polycrystalline silicon which is doped with the same conductivity type as said intermediate layer.

3. Reference diode made by the method according to claim 1, characterized in that the intermediate layer has a doping level of the order of magnitude of $10^{15}$ at/cm$^3$ and a thickness of the order of magnitude of 2 to 5 microns.

4. Reference diode according to claim 2, characterized in that the layer of polycrystalline silicon is covered with a layer of titanium, itself covered by a silver layer deposited electrolytically.

5. Reference diode obtained by the method according to claim 1, characterized in that in a part of the intermediate layer a zone of the same conductivity type but high doping level is formed to reduce the reverse breakdown voltage.

## Patentansprüche

1. Verfahren zur Herstellung einer Referenzdiode, deren Temperaturkoeffizient dV/dT gleich Null ist, wobei diese Referenzdiode eine Zenerdiode in Reihe mit wenigstens einer Diode unfaßt, deren Übergang in Vorwärtsrichtung liegt, dadurch gekennzeichnet, daß wenigstens eine dieser in Vorwärtsrichtung geschalteten Dioden als solche mit rekombinierender Elektrode ausgewählt ist, d.h. die Dicke der Zwischenschicht zwischen dem Übergang und einer Elektrode dieser Diode wesentlich geringer als der Wert der Diffusionslänge der Minoritätsträger in dieser Schicht ist, und daß Dicke der Zwischenschicht so eingestellt ist, daß der Temperaturkoeffizient der Einheit zu Null gemacht ist.

2. Referenzdiode, die durch das Verfahren nach Anspruch 1 hergestellt ist, dadurch gekennzeichnet, daß die Diode mit rekombinierender Elektrode oberhalb der Halbleiter-Zwischenschicht eine Schicht aus polykristallinem Silizium aufweist, die mit demselben Leitungstyp wie die Zwischenschicht dotiert ist.

3. Referenzdiode, die durch das Verfahren nach Anspruch 1 hergestellt ist, dadurch gekennzeichnet, daß die Zwischenschicht ein Dotierungsniveau in der Größenordnung von $2^{15}$ at/cm$^3$ und eine Dicke in der Größenordnung von 2 bis 5 Mikron aufweist.

4. Referenzdiode nach Anspruch 2, dadurch gekennzeichnet, daß die Schicht aus polykristallinem Silizium mit einer Titanschicht bedeckt ist, die ihrerseits von einer Silberschicht bedeckt ist, welche unter Vakuum abgelagert ist, gefolgt von einer elektrolytisch aufgebrachten Silberschicht.

5. Referenzdiode, die durch das Verfahren nach Anspruch 1 hergestellt ist, dadurch gekennzeichnet, daß in einem Teil der Zwischenschicht eine Zone desselben Leitungstyps, jedoch mit hohem Dotierungsniveau gebildet ist, um die Durchbruchspannung in Sperrichtung zu vermindern.

Fig. 1

Fig. 2

Fig. 4 A

Fig. 4 B

Fig. 4 C

Fig. 4 D

Fig.3

Fig.5 A

Fig. 5 B

Fig.6

2